Europäisches Patentamt

European Patent Office

Office européen des brevets

(11) Veröffentlichungsnummer: **0 234 034**
**A1**

(12) **EUROPÄISCHE PATENTANMELDUNG**

(21) Anmeldenummer: 86117472.0

(22) Anmeldetag: **16.12.86**

(51) Int. Cl.4: **H03M 1/14 , H03M 1/16**

(30) Priorität: **07.02.86 DE 3603833**

(43) Veröffentlichungstag der Anmeldung:
**02.09.87 Patentblatt 87/36**

(84) Benannte Vertragsstaaten:
**AT DE GB**

(71) Anmelder: **ANT Nachrichtentechnik GmbH**
**Gerberstrasse 33**
**D-7150 Backnang(DE)**

(72) Erfinder: **Baudisch, Werner, Ing.-grad.**
**Im Windhuck 30**
**D-3341 Denkte(DE)**

(74) Vertreter: **Wiechmann, Manfred, Dipl.-Ing.**
**ANT Nachrichtentechnik GmbH**
**Gerberstrasse 33 Postfach 11 20**
**D-7150 Backnang(DE)**

(54) **Einrichtung zur Analog/Digital-Wandlung von elektrischen Analogsignalen.**

(57) Zur Vergrößerung des Dynamikbereiches eines A/D-Wandlers (5) ist diesem ein Rechenwerk (7) nach-und ein Dynamikkompressor (2, 3, 4) vorgeschaltet, dessen Steuergröße (b) über einen Zusatz-A/D-Wandler (6) ebenfalls dem Rechenwerk zugeführt ist. Im Rechenwerk (7) wird unter Zuhilfenahme der Werte der Übertragungsfunktion und der Steuerfunktion des steuerbaren Analogverstärkers - (2) des Dynamikkompressors jeweils dasjenige digitale Ausgangswort (f) errechnet, das dem jeweiligen Abtastwert des analogen Eingangssignales (a) des Dynamikkompressors entspricht (Figur).

EP 0 234 034 A1

## Einrichtung zur Analog/Digital-Wandlung von elektrischen Analogsignalen

Die Erfindung betrifft eine Einrichtung zur Analog/Digital-Wandlung (A/D-Wandlung) von elektrischen Analogsignalen mit Hilfe eines A/D-Wandlers, dem ein Tiefpaß vorgeschaltet sein kann, wie im Oberbegriff des Patentanspruches 1 angegeben.

A/D-Wandler können nur innerhalb eines begrenzten Dynamikbereiches der Analogsignale arbeiten, vorausgesetzt, daß eine brauchbare Auflösung von ihnen verlangt wird. Außerdem sind A/D-Wandler in ihrer Abtastfrequenz beschränkt. Die gewünschte Auflösung und damit der erwartete Dynamikbereich, der die Wortgröße des digitalen Ausgangssignals (der Ausgangswörter) bestimmt, beeinflußt ebenso den Preis eines A/D-Wandlers wie die Abtastfrequenz, die bei gegebener Bandbreite des zu wandelnden analogen Eingangssignals erforderlich ist.

Es ist daher bekannt, statt eines (teueren) A/D-Wandlers einen Zweikanal-A/D-Umsetzer mit zwei - (weniger teueren) A/D-Wandlern einzusetzen oder durch den Einsatz zweier hochwertiger A/D-Wandler in dem bekannten Zweikanal-A/D-Umsetzer in höhere Frequenz-und/oder Dynamikbereiche vorzustoßen. Der bekannte Zweikanal-A/D-Umsetzer (DE-OS 24 01 452) weist einen ersten Kanal mit einer Schaltung zum Erzeugen eines über der Zeit abgetasteten Signales auf, welches proportional der Amplitude der Hüllkurve eines analogen Wchselspannungseingangssignales ist. In diesem Hüllkurvenkanal befindet sich hinter einem Hüllkurvendetektor ein erster A/D-Wandler. In einem zweiten, zum ersten parallellaufenden Kanal (Kurvenformkanal) ist eine Einrichtung zur Veränderung des analogen Eingangssignales zum Erzeugen eines Wechselspannungssignales vorgesehen, das eine im wesentlichen konstante Amplitude aufweist und einem zweiten A/D-Wandler zugeführt wird. Um diese konstante Amplitude zu erreichen, ist die Einrichtung zur Veränderung des analogen Eingangssignales mittels eines Steuersignales steuerbar, das der Hüllkurve proportional ist.

In dem bevorzugten Ausführungsbeispiel des bekannten Zweikanal-A/D-Umsetzers ist als Einrichtung zur Veränderung des analogen Eingangssignales mittels des hüllkurvenproportionalen Steuersignales im Kurvenformkanal eine Verstärkungsschalteinrichtung vorgesehen, welche eine stufenweise Veränderung der Verstärkung erlaubt und die von Digitalsignalen des ersten A/D-Wandlers gesteuert ist, der sich im Hüllkurvenkanal hinter dem Hüllkurvendetektor befindet.

Mit einer solchen Verstärkungsschalteinrichtung, deren Verstärkung aufgrund digitaler Steuersignale umgeschaltet wird, können in der Praxis Einschwingprobleme auftreten, welche die Ausgangswörter des zweiten A/D-Wandlers gegenüber idealen Ausgangswörtern verfälschen können, insbesondere bei großen Dynamiksprüngen des analogen Eingangssignals. Dadurch kann die Linearität und Auflösung des bekannten Zweikanal-A/D-Umsetzers beeinträchtigt werden.

Es ist Aufgabe der vorliegenden Erfindung, eine Einrichtung zur Analog-Digital-Wandlung von elektrischen Analogsignalen mit hoher Linearität und Auflösung anzugeben, die auch bei großen Dynamiksprüngen weitgehend erhalten bleiben.

Diese Aufgabe gelöst durch die Einrichtung mit den Merkmalen des Patentanspruches 1. Vorteilhafte Weiterbildungen sind in den Unteransprüchen angegeben.

Mit der Erfindung ist von folgenden Überlegungen ausgegangen worden: Mit Hilfe eines Dynamikkompressors ist es möglich, den Dynamikumfang von Analogsignalen zu reduzieren. Das Signal am Ausgang eines solchen analogen Dynamikkompressors, wie er in der erfindungsgemäßen Einrichtung verwendet ist, entspricht dann allerdings nicht mehr dem originalen Analogsignal, so daß nach einer anschließenden A/D-Wandlung Digitalwörter entstehen würden, die ebenfalls nicht dem originalen Analogsignal entsprechen können. Zwar könnte man die Ausgangssignale des A/D-Wandlers anschließend digital oder analog expandieren und würde so wieder Signale entsprechend den originalen Analogsignalen erhalten, jedoch führt dieser Weg nicht zu befriedigenden Ergebnissen.

Mit der Erfindung wird auf andere Weise dafür gesorgt, daß die digitalen Ausgangswörter der erfindungsgemäßen Einrichtung die jenigen Informationen enthalten, wodurch sich die digitalisierten Ausgangssignale des Dynamikkompressors von den originalen Analogsignalen, also von den Eingangssignalen des Dynamikkompressors unterscheiden. Diese Informationen sind in der Steuergröße verborgen, welche die Verstärkung desjenigen steuerbaren Analogverstärkers analog steuert, der in dem Dynamikkompressor enthalten ist. Diese Steuergröße wird innerhalb der erfindungsgemäßen Einrichtung einem Zusatz-A/D-Wandler zugeführt, dessen Ausgangswörter zusammen mit den Ausgangswörtern des A/D-Wandlers, der dem Dynamikkompressor nachgeschaltet ist, in ein Rechenwerk gelangen. Dort werden die Ausgangswörter des A/D-und des Zusatz-A/D-Wandlers zu Ausgangswörtern der erfindungsgemäßen Einrichtung miteinander verknüpft, welche den analogen Eingangssignalen des Dynamikkompressors entsprechen.

Verfälschungen der digitalen Ausgangswörter des A/D-Wandlers bei Dynamiksprüngen werden dabei dadurch weitgehend vermieden, daß der Analogverstärker im Dynamikkompressor analog gesteuert wird. Dadurch kann sich seine Verstärkung schnell und wenig durch Einschwingvorgänge gestört den Dynamiksprüngen anpassen.

Dem Rechenwerk muß die Steuerkennlinie - (Steuerfunktion) des steuerbaren Verstärkers eingegeben werden, damit es seine digitalen Ausgangswörter errechnen kann.

Durch die Benutzung eines steuerbaren (Bevorzugt spannungssteuerbaren) Verstärkers mit logarithmischer Steuerkennlinie gelingt es, dem Rechenwerk eine Funktion zur Verfügung zu stellen, die leicht definierbar ist, selbst wenn Eingangspegelverschiebungen auftreten.

Bevorzugt enthält der Dynamikkompressor einen Regelkreis, bei dem der Spitzenweggleichrichter im Signalfluß erst hinter dem gesteuerten Analogverstärker angeordnet ist. Solche Dynamikkompressoren sind nämlich gerade für analoge Eingangssignale mit hoher Dynamik und starken Dynamiksprüngen (insbesondere für Tonfrequenzsignale in Studioqualität) bereits bestens optimiert auf dem Markt, so daß sich die Einrichtung zur Analog/Digital-Wandlung damit ohne großen Entwicklungsaufwand aufbauen läßt.

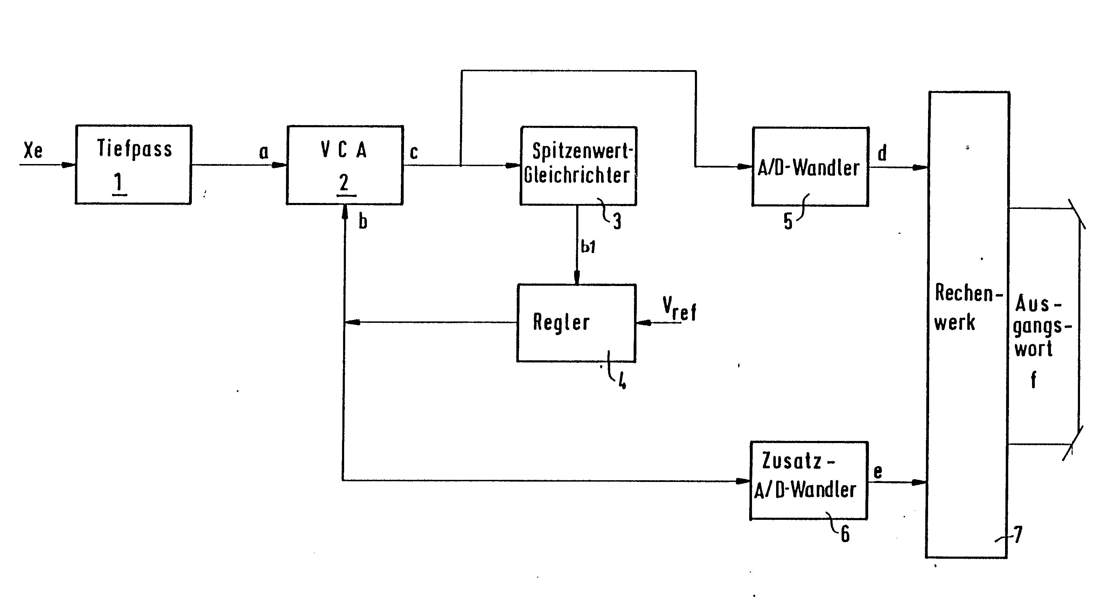

Anhand des in der Zeichnung dargestellten Ausführungsbeispieles wird die Erfindung näher erläutert.

Elektrische Analogsignale Xe durchlaufen einen Tiefpaß 1, der ihre Flankensteilheit soweit begrenzt, daß der nachfolgende Regelkreis funktionsgerecht arbeitet. Das Ausgangssignal des Tiefpaßes 1 wird einem analogen Dynamikkompressor als dessen analoges Eingangssignal a zugeführt. Der Dynamikkompressor kann einen Kompressionsgrad zwischen Null und 100% haben und besteht aus einem Regelkreis, dessen zentraler Bestandteil ein in seiner Verstärkung analog steuerbarer Analogverstärker 2, beispielsweise ein spannungsgesteuerter Verstärker (VCA), ist. Dessen analoge Ausgangssignale c sind zugleich die Ausgangssignale des Dynamikkompressors und gelangen einerseits zu einem A/D-Wandler 5 und andererseits in die Regelschleife des Regelkreises mit einem Spitzenwertgleichrichter 3, dessen Ausgangsgröße (hüllkurvenabhängiges Signal b1) in einem nachgeschalteten Regler 4 mit einer Referenzgröße Vref verglichen wird. Das Vergleichsergebnis bildet eine analoge Steuergröße b, die einerseits dem Steuereingang des steuerbaren Analogverstärkers 2 und andererseits einem Zusatz-A/D-Wandler 6 zugeführt ist.

Dem A/D-Wandler 5 und dem Zusatz-A/D-Wandler 6 ist ein gemeinsames Rechenwerk 7 nachgeschaltet, das aus den digitalen Ausgangswörtern der beiden Wandler 5 und 6 laufend digitale Ausgangswörter f der gezeigten Einrichtung bildet. Bei der Errechnung der Ausgangswörter f gehen die Werte der Übertragungs- und der Steuerfunktion des Analogverstärkers 2 mit in das Ergebnis ein. Diese Werte sind entweder in dem Rechenwerk gespeichert oder werden diesem von einem externen Speicher zugeleitet.

Arbeitsweise:

Im eingeschwungenen Zustand, wenn also das Eingangssignal a beispielsweise eine Sinusspannung konstanter Amplitude ist, wird mit Hilfe des Reglers 4 der Analogverstärker 2 so gesteuert, daß sich eine Ausgangswechselspannung c konstanter Amplitude ergibt und daß das gleichgerichtete Ausgangssignal b1 des Spitzenwertgleichrichters 3 einen Mittelwert aufweist, der gleich der Referenzgröße Vref, beispielsweise einer Gleichspannung, ist. Bei konstanter Eingangsamplitude des Eingangssignales a steht somit unabhängig von der Größe von dessen Amplitude am A/D-Wandler 5 immer ein Signal (beispielsweise Sinusspannung) mit konstanter Amplitude an.

Im nicht eingeschwungenen Zustand, also bei nicht konstanter Amplitude des Eingangssignales a wird durch die Regelschaltung versucht, die Amplitude des Signales c auf einen konstanten Wert zu regeln.

Da das Signal c eine Funktion des Eingangssignales a entsprechend der jeweiligen (durch die Steuergröße b steuerbaren) Übertragungsfunktion des Analogverstärkers 2 ist und das Signal c außerdem eine Funktion der Steuergröße b entsprechend der Steuerfunktion des Analogverstärkers 2 ist, ist es möglich, aus den digitalisierten Werten der Signale c und b, also aus den Ausgangsworten d und e die digitalisierten Werte des Eingangssignales a mit Hilfe des Rechenwerkes 7 zu berechnen (sofern die reziproke Übertragungsfunktion des Analogverstärkers 2 mit Hilfe des Rechenwerkes 7 darstellbar ist).

Das Rechenwerk 7 muß die durch die Ausgangwörter d und e gebildeten digitalen Abtastwerte der Signale c und b so verarbeiten, daß immer zeitlich zueinander gehörende Werte der Signale c und b zur Berechnung eines Ausgangswortes f verwendet werden.

Die Regelschaltung im Dynamikkompressor 2, 3, 4 ist so zu dimensionieren, daß der steuerbare Analogverstärker 2 beim maximal möglichen Pegelsprung des Eingangssignales a nicht übersteuert wird.

Da der mittels moderner steuerbarer Analogverstärker bearbeitbare Dynamikbereich größer ist als der Dynamikbereich bekannter A/D-Wandler und da das Signal c eine geringere Dynamik als das Eingangssignal a aufweist, kann mit der Einrichtung nach der Erfindung eine A/D-Wandlung über einen größeren Dynamikbereich vorgenommen werden, als mit dem A/D-Wandler 5 allein. Dabei kann man den A/D-Wandler 5 mit Hilfe des Dynamikkompressors weitgehend im Bereich einer hohen Aussteuerung arbeiten lassen, wodurch die Auswirkung der im A/D-Wandler 5 erfolgenden Quantisierung gering gehalten werden kann.
Mit Hilfe des Rechenwerkes 7 kann das Ausgangswort f in jede gewünschte Form (linear, Gleitkomma, etc.) gebracht werden.

**Ansprüche**

1. Einrichtung zur Analog/Digital-Wandlung von eingangsseitig zugeführten, elektrischen Analogsignalen (Xe) mit Hilfe eines A/D-Wandlers (5), dem ein Tiefpaß (1) vorgeschaltet sein kann,
mit einem Dynamikkompressor (2, 3, 4), der dem A/D-Wandler (5) vorgeschaltet und gegebenenfalls dem Tiefpaß (1) nachgeschaltet ist, wobei der Dynamikkompressor (2, 3, 4) einen steuerbaren Analogverstärker (2) aufweist, dessen Verstärkung hüllkurvenabhängig im Sinne der Dynamikkompression steuerbar ist, und wobei ein Zusatz-A/D-Wandler (6) für hüllkurvenabhängige Signale (b1) vorgesehen ist, die mit Hilfe eines Spitzenwertgleichrichters (3) aus Analogsignalen (c, Xe) gewonnen sind, dadurch gekennzeichnet, daß die Verstärkung des Analogverstärkers (2) im Sinne der Dynamikkompression mit Hilfe einer analogen Steuergröße (b) steuerbar ist, die von hüllkurvenabhängigen Signalen (b1) hergeleitet ist, und daß die Steuer kennlinie des Analogverstärkers (2) logarithmisch verläuft.

2. Einrichtung nach Anspruch 1, dadurch gekennzeichnet, daß zur Herleitung der Steuergröße (b) ein Regler (4) vorgesehen ist, dem auch der Zusatz-A/D-Wandler (6) nachgeschaltet ist, wobei der Regler auch einen Eingang für eine Referenzgröße (Vref) aufweist.

3. Einrichtung nach Anspruch 1 oder 2, dadurch gekennzeichnet , daß dem A/D-(5) und dem Zusatz-A/D-Wandler (6) ein gemeinsames Rechenwerk (7) nachgeschaltet ist zur laufenden Bildung digitaler Ausgangswörter (f), welche durch Verknüpfung der digitalen Ausgangswörter des A/D-(5), des Zusatz-A/D-Wandlers (6), der Übertragungs-und der Steuerfunktion des Analogverstärkers (2) digitale Abtastwerte des analogen Eingangssignales (a) des Dynamikkompressors oder des Spitzenwertgleichrichters (3) repräsentieren.

4. Einrichtung nach einem der vorangehenden Ansprüche, dadurch gekennzeichnet, daß der Dynamikkompressor einen Regelkreis aufweist, in welchem der Spitzenwertgleichrichger (3) dem Analogverstärker (2) nachgeschaltet ist.

5. Einrichtung nach einem der vorangehenden Ansprüche, dadurch gekennzeichnet, daß der Dynamikkompressor (2, 3, 4) und der A/D-Wandler (5) so aneinander angepaßt sind, daß der A/D-Wandler (5) im Bereich mittlerer bis höherer Auflösung arbeitet.

6. Einrichtung nach einem der vorangehenden Ansprüche, dadurch gekennzeichnet, daß der Kompressionsgrad des Dynamikkompressors (2, 3, 4) größer als Null und kleiner als 100% ist.

Tiefpass 1

Xe

VCA 2

a

c

b

Spitzenwert-Gleichrichter 3

b1

Regler 4

V_ref

A/D-Wandler 5

d

Zusatz-A/D-Wandler 6

e

Rechen-werk 7

Ausgangs-wort f

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-2 934 741 (GRAY) <br> * Seite 2, Zeile 6 - Seite 4, Zeile 46; Figur 1 * | 1-2,4 | H 03 M 1/14 <br> H 03 M 1/16 |
| Y,D | US-A-3 815 124 (BREWER) <br> * Zusammenfassung * | 1-2,4 | |
| A | US-A-2 967 292 (EISHER) | | |
| A | FR-A-1 303 755 (PRAKLA) | | |

RECHERCHIERTE
SACHGEBIETE (Int. Cl.4)

H 03 M 1/14
H 03 M 1/18
H 03 M 1/16
H 03 G 3/20
H 03 G 7/00
G 01 V 1/24

Der vorliegende Recherchenbericht wurde für alle Patentansprüche erstellt.

| Recherchenort | Abschlußdatum der Recherche | Prüfer |
|---|---|---|
| DEN HAAG | 16-04-1987 | GUIVOL Y. |